# EUROPEAN PATENT SPECIFICATION

(11) **EP 3 365 633 B1**
(45) Date of publication and mention of the grant of the patent: **26.02.2020**
(21) Application number: 15784355.8
(22) Date of filing: 21.10.2015
(51) Int. Cl.: G01D 4/00, G06Q 50/06, G06Q 50/00

(54) **METER OF A SUPPLY SYSTEM AND SUPPLY SYSTEM**
VERBRAUCHSZÄHLER EINES VERSORGUNGSSYSTEMS UND VERSORGUNGSSYSTEM
COMPTEUR DE SERVICES D'UN SYSTÈME D'ALIMENTATION ET SYSTÈME D'ALIMENTATION

(43) Date of publication of application: 29.08.2018
(73) Proprietor: INNOGY INNOVATION GMBH, 45139 Essen (DE)
(72) Inventor: STÖCKER, Carsten, 40724 Hilden (DE); WAFFNER, Jürgen, 45307 Essen (DE)
(74) Representative: Cohausz & Florack
(86) International application number: PCT/EP2015/074342
(87) International publication number: WO 2017/067587

(56) References cited:
- WO-A1-2013/182226
- DE-A1-102010 026 174
- IE-A2- 20 060 867
- US-A1- 2013 218 495
- US-B1- 7 385 524

## Description

The invention relates to a meter of a supply system comprising at least one measuring module configured to measure at least one quantity parameter of a supply medium flowing through a supply channel. Furthermore, the invention relates to a supply system comprising a meter and a method for operating a meter.

According to prior art, entities can be supplied by a supply medium using supply systems. Examples of supply systems are electrical supply systems, gas supply systems, water supply systems and district heating systems.

A supply system of the present invention comprises a physical, in particular, grid-bound supply channel network. The supply medium is transferred via the supply channel network. For instance, the supply medium is electrical current or electrical power, water, such as fresh water, waste water or water for watering, gaseous media, such as natural gas or a similar gas, heat, such as warm air, or coldness, such as cold air.

A physical supply channel network can comprise at least one grid-bound supply channel. By way of example, the at least one grid-bound supply channel can be an electrical connection, such as an energy cable, preferably a plurality of energy cables, or a fluid connection, such as a pipeline, preferably a plurality of pipelines.

The supply channel network can be at least partly a public supply channel network and/or at least partly a private supply channel network, such as a stand-alone grid.

Furthermore, at least two entities can be connectable to the (same) supply channel network. An entity can comprise at least one consumer. The at least one consumer can be supplied by a producer with supply medium via the supply channel network. In order to detect the amount of consumed supply medium by an entity, the entity usually comprises a meter. The meter can be configured to determine a quantity parameter of the supply medium obtained by the entity. For instance, a flow rate of a supply medium obtained by the entity can be measured. In particular, an entity comprises a supply channel, such as a house connection, which is connectable to the physical supply channel network. The house connection enables receiving of supply medium from the physical supply channel network and/or the delivery of the supply medium to the physical supply channel network. The meter can measure the flow rate, like the volume of fluid which passes per unit time the house connection. In the case of an electrical meter, the meter can measure the amount of electric power consumed or supplied by the entity by measuring electrical parameters from the house connection.

What is common to the entire prior art supply systems is that a central system, central process and/or central organisation is provided. Such a system is configured to control the acquisition and sale of the supply medium. In order to correctly controlling these processes, each meter can be read out and the quantity parameter can be transmitted to the central system. For instance, the meter of prior art can be manual readable meter or a remote meter. Based on the received quantity parameters of the supply medium measured by a meter, the central system controls the acquisition and sale of the supply medium.

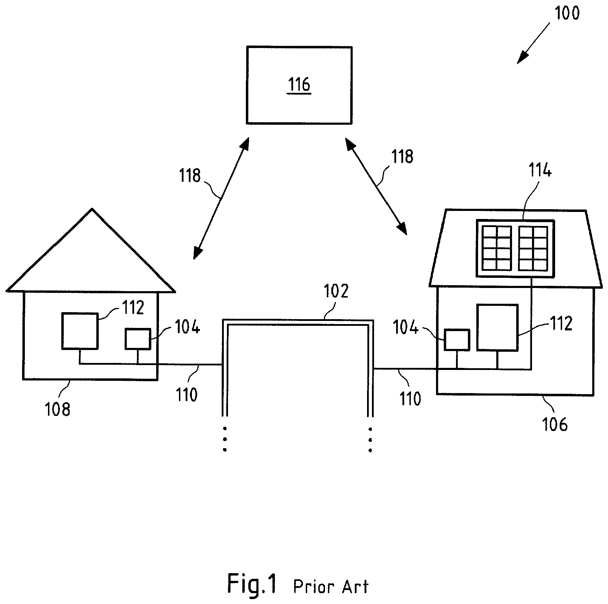

Based on an example of an electrical supply network or grid shown in figure, a typical prior art supply system 100 will be explained. The figure 1 shows an embodiment of a supply system 100 according to prior art. The depicted supply system 100 comprises at least one physical supply channel network 102. For instance, one or more electrical lines, such as ground wires and/or overhead wires, can be provided. In addition, (not shown) transformers and the like can be comprised by the physical supply channel network 102.

By a respective supply channel, such as the electrical connection lines 110, a first entity 106 and a further entity 108 are connected to the physical supply channel network 102. For example, the entities 106 and 108 are buildings. The first entity 106 comprises an electrical consumer 112 and an electrical producer 114, e.g. a photovoltaic device 114. Such an entity 106 can be denoted as a prosumer (producer and consumer).

The quantity parameter of the supply medium flowing through the supply channel 110, in particular the quantity of electrical power received from the supply channel network 102 and the quantity of electrical power delivered to the supply channel network 102, is (continuously) measured by an electrical meter 104. The electrical meter 104 can transmit the measured quantity parameter to a central server 116, e.g. via an additional client device and the communication link 118.

The further entity 108 only comprises an electrical consumer 112. Such an entity 108 can be denoted as a consumer. Also the entity 108 comprises a meter 104 for measuring the electrical power consumed by the entity 108, in particular, by measuring the supply medium quantity flowing through supply channel 110. The electrical meter 104 or another client device can transmit the measured quantity parameter to the central server 116 e.g. via communication connection 118.

It shall be understood that an entity 106, 108 can usually comprise a plurality of consumers 112.

The central server 116 is configured to manage the supply system 100. For instance, each entity 106, 108 can generate a general supply medium transaction agreement comprising at least one transaction criterion with a supply medium operator via the central server 116.

In the case, the first entity 106 delivers electrical power to the further entity 108, the respective meters 104 measures the power flow and transmit the respective supply medium quantity parameters to the central server 116, e.g. upon request by the central server 116 or via a manual meter reading process. Then, the central server 116 verifies the received meter data, thus ensuring a correct settlement between the central server and the respective clients of the entities 106, 108. In other words, according to prior art, it is always necessary that a central instance 116, like the server 116, is provided for monitoring, managing, verifying and billing an exchange of supply medium quantity between two entities 106, 108.

The document US 7 385 524 B1 describes an example of such prior art supply systems.

In addition to the high transaction costs a disadvantage of such client-server structures, in particular of the server (or platform), is that the central authority or the central server has to manage customer data. A persistent problem of a centralized system is the protection of customer data stored one or more server against access of unauthorized third parties. In particular, a large safety-related effort is needed to prevent a manipulation of, for example, the customer data, billing data, forecast data, etc. This in turn results in higher transaction costs.

Therefore, it is an object of the present invention to provide a meter of a supply system, which improves the exchange of supply medium between entities and provides for a high security.

The object is solved according to a first aspect of the present invention by a meter of a supply system according to claim 1. The meter of the supply system comprises at least one measuring module configured to measure at least one quantity parameter of a supply medium flowing through a supply channel. The meter comprises at least one peer-to-peer module configured to communicate with a peer-to-peer application of a peer-to-peer network. The measuring module is configured to provide the measured quantity parameter of the supply medium to the peer-to-peer module via a communication connection arranged between the measuring module and the peer-to-peer module. The peer-to-peer module is configured to provide at least the measured quantity parameter to the peer-to-peer application.

In contrast to the prior art, an improved and secure exchange of supply medium between two entities can be ensured by a meter according to the invention in a simple manner without a central instance by replacing the central server or the central platform by a peer-to-peer network (i.e. a framework). A tamper-proof generation verification of measured supply medium parameter can be ensured by means of a peer-to-peer application. In a peer-to-peer network high safety standards are achieved by preferably all computers (peer nodes) of the network, at least a subset of the peer computer network, monitor the correctness of the meter data. Transaction costs can be significantly reduced. There is no central, overarching platform, server, cloud, etc. required. Since the measuring module and the peer-to-peer module are comprised by the meter, the safety is further improved. In particular, the risk of a manipulation of the measured quantity parameters by attacking or manipulating the communication connection between a measuring module and a peer-to-peer module can be at least reduced due to the avoidance of a communication connection outside the meter. A further advantage of the present invention is that installation costs are reduced due to the fact that meter and the peer-to-peer module are provided, installed and pre-configured within one device entity.

The meter is used within a supply system for measuring the amount of supply medium passing a supply channel monitored by the meter. The supply system according to the invention is characterized by a supply channel network for transmitting at least one supply medium between at least two entities connectable with the supply channel network. Exemplary and non-exhaustive supply systems are electrical supply networks, gas supply networks, water supply networks and district heating networks.

Depending on the type of supply system the supply medium transferred via a suitable physical, in particular grid-bounded supply channel, can be electric current or electric power, water, such as fresh water, waste water or water for irrigation, gaseous fluid, such as natural gas or similar (combustible) gases, heat, for instance transmitted or exchanged in the form of hot air, and/or cold, for example in the form of cold air.

The supply channel network can be at least partially a public supply channel network and/or at least partially a private supply channel network. For example, the network is a separate microgrid (only) for the entities of the supply system or a virtual microgrid. Preferably there may be a public network.

In particular, the supply system can comprise at least a first entity and another entity at least connectable to each other via respective suitable supply channel and the physical supply channel network. The supply channel of an entity corresponds to the physical supply channel network and can be, for example, an electrical line or a fluid pipe. The meter according to the present invention can be configured to monitor the supply flow of a supply medium. For instance, at least the measuring module of the meter can be connectable to the supply channel.

It shall be understood that a supply system may include three or more entities. According to the present application, a supply system is in particular a supply system wherein at least one entity produces the supply medium, and preferably, can feed the produced supply medium into a line of the physical supply channel network and wherein at least another entity receives/removes the supply medium from a line of physical supply channel network and may preferably consume the supply medium. It shall be understood that an entity can be a prosumer or consumer. In such supply networks, it is desirable that the feeding volume and the removing volume (always) compensate each other. In particular, a supply channel system is presently characterized in that it has a limited capacity.

An entity can be configured to exchange supply medium with at least one other entity via the physical supply channel grid. The exchanged supply medium of an entity can be measured by the present meter. Generally, a supply system may include different types of entities, so long as they can be connected to the physical supply channel network. An entity may be, for example, a building, part of a building, like an apartment, a single (intelligent) device or machine, a company or the like. Each if these entities might comprise a meter according to the present invention.

The present (smart) meter is characterized in that it comprises the measuring module and a peer-to-peer module. As described above, the measuring module is configured to measure by suitable measuring means (depending on the supply medium) the amount of the supply medium flowing through the supply channel. The measured quantity parameters or quantity parameter values are forwarded to the peer-to-peer module of the meter via a (single) communication connection. The peer-to-peer module might be a mini-computer, micro controller or the like.

The peer-to-peer module is configured to communicate with a peer-to-peer network also called computer-computer network. In comparison to a client-server network in which a server provides a service and a client uses the service, these roles are cancelled in a peer-to-peer network. Each participant of the peer-to-peer network can use a service and the like and offer such a service. In particular, a peer-to-peer network is self-determined and/or self-organized (without any higher-level units). In the present case preferably each computer of the peer-to-peer network comprises a peer-to-peer application. In particular, the peer-to-peer module is configured to send messages to the peer-to-peer application and/or read data stored in the peer-to-peer application.

The peer-to-peer network is at least configured to store the measured supply medium quantity parameters. Thereby, the peer-to-peer module is configured to provide the respective data to the peer-to-peer application, e.g. by transmitting a message comprising the at least one quantity parameter. The peer-to-peer application is characterized in that the peer-to-peer application or the data content of the peer-to-peer application is accessible from preferably by all participants of the peer-to-peer network. It shall be understood that two or more, in particular different peer-to-peer applications can be provided.

A measured supply medium quantity parameter may in particular comprise (besides the measured amount of a supply medium per time unit) information of the meter or peer-to-peer module of the meter, such as a unique ID and/or hash code, like an address of the peer-to-peer module known to at least a part, preferably all participants of the peer-to-peer network, an ID of a supply medium transaction agreement related to the measured supply medium quantity parameter, and the like. By appropriate check and/or validation algorithms, such as digital signatures and/or hash functions, the correctness and/or immutability of a measured supply medium quantity parameter can be ensured especially by the cumulative processing power of the computers of the peer-to-peer network.

It is noted that the meter can comprise an (internal) timer. The timer can provide time information via the peer-to-peer module to the peer-to-peer application for validation of the time information. For instance, the time information can be compared with a reference time provided by the peer-to-peer application. Thereby, it is possible to check the time information, in particular each time information, and/or calibrate preferably each timer of preferably each meter by means of the peer-to peer network. A centralized system is not required.
According to a first embodiment of the meter of the present invention, the meter comprises a housing and at least a part of the measuring module and the peer-to-peer module are comprised by the housing. Preferably, the measuring module and the peer-to-peer module are fully integrated in the housing. The housing is in particular a tamper-proof housing configured to prevent a manual manipulation of the components integrated in the housing. By way of example, the meter may be configured such that the supply channel to be monitored extends through the housing. For instance, the housing might comprise an inlet connection and an outlet connection for connecting respective supply channel connections. By conducting the supply channel through the housing of the meter, the measuring unit can be fully integrated within the housing, thus further reducing the manipulation risk.

In another embodiment, the housing of the meter can comprise at least one module slot configured to receive at least a peer-to-peer module. For instance, for providing the meter with a peer-to-peer module, the respective module can be inserted into the module slot of the meter. An authentication mechanism can be provided which can secure the communication between the measuring module and the inserted peer-to-peer module.

Furthermore, it is noted that the meter might be a mobile meter and or a non-mobile meter.

In general, the measuring module of the meter depends on the supply medium flow to be monitored and measured. According to an embodiment of the present meter, the at least one measuring module can be selected from the group of electrical measuring module, fluid measuring module or heat measuring module. An electrical measuring module can be configured to measure an electrical current and/or electrical power per time unit. The fluid measuring module can be configured to measure the volume of a fluid, such as a gas or liquid, passing the supply channel per time unit. Eventually, the heat or cold measuring module may be configured to measure the consumed/delivered heat/cold.

In order to further improve the communication security between the measuring module and the peer-to-peer module, according to a preferred embodiment the communication connection between the measuring module and the peer-to-peer module is a wired communication connection. Eavesdropping of and manipulating the communication can be made more difficult. Further the communication connection between the measuring module and the peer-to-peer module can be an unidirectional communication connection from the measuring module to the peer-to-peer module. This reduces the risk of a manipulation of the measuring module via an interface of the peer-to-peer module and the connection between the measuring module and the peer-to-peer module.

Furthermore the meter can be preferably associated with a first entity. For instance, the entity can be installed at the supply channel, such as the entity connection with the supply channel network, of the first entity. The peer-to-peer module can be configured to cause a generation of a supply medium transaction agreement about the exchange of a supply medium between the first entity and a further entity by the peer-to-peer application, in particular, via the physical supply channel network. Also the further entity can comprise a meter according to the present invention. The peer-to-peer module of a meter associated with an entity can be adapted to cause a generation of supply medium transaction agreement between the associated entity and a further entity, for example, by sending a message comprising instructions to generate a supply medium transaction agreement to the peer-to-peer network. In particular, a suitable code and, if necessary, at least one key to verify the sender of a message and/or the authenticity of a message can be transmitted to the peer-to-peer application or written into the peer-to-peer application from the peer-to-peer module of the meter. Preferably, upon an acceptance message comprising suitable instructions and optionally at least one key to verify the sender of the acceptance message from the other entity, e.g. from a peer-to-peer module of another meter associated to the other entity, and after a review by the peer-to-peer network a corresponding supply medium transaction agreement can be generated. In simple terms, any peer-to-peer module can select one or more suitable partners for the exchange of a supply medium quantity using the peer-to-peer network or the peer-to-peer application. Further, a peer-to-peer module can cause the generation of a supply medium transaction agreement by means of the peer -to-peer application. A supply medium transaction agreement may in particular comprise information about at least the two participating entities or respective peer-to-peer modules, such as a unique ID and/or hash code, the agreed amount of a supply medium to be exchanged during an agreed future time period and/or at least one transaction criterion. After the exchange of the agreed amount of supply medium, preferably the meter of each involved entity can transmit the respectively measured quantity of supply medium of the agreed time period to the peer-to-peer application, as described hereinbefore.

In a further embodiment, the peer-to-peer network is formed by a plurality of computer nodes and the peer-to-peer module is only configured to communicate with the plurality of computer nodes. In other words, the peer-to-peer module is not a computer node of the peer-to-peer network. Such a peer-to-peer module does not comprise the peer-to-peer application but only provides an interface module, such as an application programming interface (API), and a decentral application for communication with the computer nodes of the peer-to-peer network or the peer-to-peer application, such as a block chain. This allows reducing the required processing power of the peer-to-peer module.

In an alternative embodiment, the peer-to-peer network is formed by a plurality of computer nodes and the peer-to-peer module is one of the computer nodes. In this case, the peer-to-peer module comprises at least a part of the peer-to-peer application. For instance, the peer-to-peer module might be a so called light node. In particular, the peer-to-peer module can comprise preferably the total data content of the peer-to-peer application.

In addition, according to an embodiment of the present meter, the peer-to-peer module can be configured to generate at least one request message and/or at least one acceptance message based on a supply medium plan created for an entity associated with the peer-to-peer module. A present supply medium plan is characterized in that it comprises an individual, in particular for each entity, forecast for at least one period in the future in terms of demand and/or offer of a supply medium. An entity may comprise any suitable means or be connected to this to create a supply medium plan. For example, the creation of the supply medium plan can be based on historical data regarding the recent demand/offer of a supply medium, (external) forecast data, such as weather data, and/or user preferences, such as calendar information, whereabouts of a person (including predict when residents come home and/or when a company starts processing), level data of an electrical storage, such as a battery, etc.. In practice there can be two options for an external data feed: A data feed can be established and agreed upon on the peer-to-peer application, such as a blockchain/decentral ledger, and a data feed can come via a gateway which is connected to the peer-to-peer application, such as a blockchain/decentral ledger, or an external data feed can directly be connected to the the peer-to-peer application, such as a block chain/decentral ledger. The preparation of a (optimized) supply medium plan of the particular entity can be performed by the peer-to-peer module or another local module configured to communicate with the peer-to-peer module.

For example, in a gas supply system, the supply medium plan can be created based on the historical consumption of gas by the entity. In addition, for example, weather forecasts, such as temperature data are taken into account. Similarly, supply medium plan can be created in other supply systems. Based on the supply medium plan the peer-to-peer module can transmit a request message to the peer-to-peer network, in particular to the peer-to-peer application described above. Preferably, each entity and its associated peer-to-peer module can read the transmitted information. In one embodiment, a peer-to-peer module can generate based on a (own) supply medium plan and on a request message of another entity an acceptance message and, in particular, transmit this message to the peer-to-peer network, such as the above-described peer-to-peer application. In a simple manner a particular suitable supply medium transaction agreement can be prepared by means of the peer-to-peer network and the peer-to-peer application.

In a preferred embodiment, a request message can comprise a supply medium quantity, time period and/or at least one transaction criterion. Preferably, a request message may include at least the aforementioned data. Further, an identifier of the sender, such as a unique identifier, e.g. an unique address known to each participant of the peer-to-peer network, a timestamp, additional transaction criteria, etc. may be included in a request message. Alternatively or additionally it can be provided that an acceptance message comprises a supply medium quantity, time period, and/or at least one transaction criterion. Preferably, an acceptance message comprises at least the aforementioned data and, in particular, a reference to a request message of another entity. Further, an identifier of the sender, such as a unique address known to each participant of the peer-to-peer network, a timestamp, additional transaction criteria, etc., may be included in an acceptance message.

According to a further embodiment of the meter according to the present invention, the peer-to-peer module can be configured to cause a generation of a transaction criterion transaction based on a transaction criterion specified in the supply medium transaction agreement and the measured quantity parameter. Preferably, depending on a positive previously described review of the measured quantity parameters of a delivered/received supply medium quantity, the peer-to-peer module may be arranged to cause a generation of a transaction criterion transaction. For example, a certain amount of a crypto currency can be established as a transaction criterion. In the case the delivery was carried out according to the supply medium transaction agreement, by means of peer-to-peer network, in particular by the peer-to-peer application, the specified amount can be transferred in a transaction criterion transaction. Similarly as described above, also in this transaction unique keys of the peer-to-peer modules can be used for verification. The keys and in particular the actual possession of the amount by a peer-to-peer module or associated entity can be verified by the peer-to-peer network, such as described above. A secure payment by means of a peer-to-peer network without central authority can be provided. Transaction costs can be further reduced.

Furthermore, according to another embodiment, the peer-to-peer module can be further configured to communicate with at least one further meter via a wired connection or wireless connection. The further meter can comprise a further measuring module and a communication module. The further meter can also be called a secondary meter while the meter comprising the peer-to-peer module can also be called primary meter. The further measuring module of the secondary meter can be configured to measure a sub-flow of the supply medium flow measured by the primary meter or to measure another supply medium flow than the primary meter. By way of example, the primary meter can be an electric meter while the secondary meter can be a gas meter, water meter or a meter measuring the power consumption of a particular consumer or measuring the power provided by a particular producer.

Preferably, the secondary meter can be connected via a secure connection, such as a secure wired connection. This enables to transmit the measuring data from the secondary meter to the primary meter in a secure manner. Then, the peer-to-peer module can provide at least the meter data of the secondary meter to the peer-to-peer application, as explained above. Hence, it is not necessary to integrate a peer-to-peer module in every meter e.g. of an entity but only in one (primary) meter. In other words, the at least one secondary meter (which does not comprise a peer-to-peer module) can be connected to the peer-to-peer network or another peer-to-peer network via the primary meter.

A further aspect of the present invention is a supply system comprising at least one previously described meter, at least one supply channel configured to transport at least one supply medium and at least one peer-to-peer network configured to provide a peer-to-peer application. The supply system comprises preferably at least two entities. Each entity can comprise at least one meter. Furthermore, the supply system is configured such that a supply medium can be exchanged between the entities, as explained above.

According to a preferred embodiment of the supply system, the peer-to-peer application is a decentralized register. The decentralized register can be readable at least by a part of the participants of the peer-to-peer network. In particular, every computer node including the peer-to-peer module of the meter can comprise the peer-to-peer application. The decentralized register may be read at least by each participant of the peer-to-peer network. In particular, all peer-to-peer modules and all other computers of the peer-to-peer network can preferably read all information in the peer-to-peer application formed as a register. Preference is also that all peer-to-peer modules and all other computers of the peer-to-peer network can send messages to or write messages to the peer-to-peer application. In a simple way information can be made available to preferably all participants. This allows to carry out a review of the information stored in the decentral register. Particularly preferably, each computer in the peer-to-peer network is configured to review new information, in particular based on older information stored in the peer-to-peer application.

Moreover, preferably each computer can in each case comprise the complete data content, but include at least a portion of the data contents of the peer-to-peer application, in particular of the decentral register. For example, it may be provided that after a positive verification of written information in the peer-to-peer application this information is saved by all computers, at least from a part of the computers. The tamper resistance of the data stored in the peer-to-peer application can thereby be further improved.

In order to store new information in a tamper-proof way, the peer-to-peer application can comprise encryption means and/or signature means and/or verification means, wherein at least one of the encryption means and/or signature means and/or verification means is configured to store at least the provided quantity parameter. At least one means of the aforementioned means may be adapted to store at least every provided quantity parameter. In particular it can be provided that by the hash function a link is established with at least one previously stored information in the decentral register. Further data, such as request messages, ordinary, contextual and/or transaction data of an entity can be stored.

In a particularly preferred embodiment of the system, the peer-to-peer application can be a block chain comprising at least two interconnected blocks. The block chain technology or "decentral ledger technology" is already used in the payment by means of a crypto currency, such as Bitcoin. It has been recognized that by a particular configuration of a block chain, at least the correctness of the measured supply medium amount can be checked without the need of a central server. In addition, the block chain can be used to generate a supply medium transaction agreement between two entities in a tamper-proof manner. The block chain according to the present embodiment is particularly a decentralized, peer-to-peer-based register in which all measured supply medium parameters and preferably all supply medium transaction agreements and other messages sent be peer-to-peer modules can be logged. A block chain is particularly suitable as a technical means to replace a central entity in a simple and secure manner.

Furthermore, in a preferred embodiment of the supply system, the supply system can comprise a further meter having at least one communication module configured to communicate with the peer-to-peer module via a wired connection or wireless connection. The further meter can be a secondary meter (which does not comprise a peer-to-peer module) and the meter comprising the peer-to-peer module can be a primary meter, as described hereinbefore.

A further aspect of the present invention is a method for operating a meter of a supply system, in particular, a previously described meter. The method comprises:
- measuring at least one quantity parameter of a supply medium by the measuring module,
- transmitting the at least one quantity parameter from the measuring module to the peer-to-peer module via a communication connection arranged between the measuring module and the peer-to-peer module, and
- providing at least the measured quantity parameter to a peer-to-peer application of a peer-to-peer network by the peer-to-peer module.

The method can be a computer program comprising instructions for causing a processor to operate a meter as described above.

In addition, according to an embodiment, meter status information can be provided to a peer-to-peer application of a peer-to-peer network by the peer-to-peer module. Meter status information can be used to assess the quality and/or availability and/or correctness of meter data in order to improve e.g. a forecast, auto-correct false data and/or identify manipulation.

It is noted that in the present case, according to an embodiment, the peer-to-peer module comprises at least an API configured to communicate with the peer-to-peer application, such as the block chain. In addition to the API, the peer-to-peer module comprises a decentral application of software comprising local algorithms at least configured to create and transmit the measured quantity parameter to the peer-to-peer application via the API. The decentral application is at least configured to process and transmit the meter data.

Preferably, the data can be transmitted via a cryptographically secured tunnel to a peer-to-peer node running the peer-to-peer application, such as the block chain. In another particular embodiment, also the peer-to-peer application itself is implemented in the peer-to-peer module, i.e. the peer-to-peer module is a node of the peer-to-peer network comprising the decentral application, the API and the peer-to-peer application, such as the block chain or decentral ledger.

These and other aspects of the present patent application become apparent from and will be elucidated with reference to the following figures. The features of the present application and of its exemplary embodiments as presented above are understood to be disclosed also in all possible combinations with each other.

In the figures show:
- Fig. 1: a schematic view of an embodiment of a supply system according to prior art;
- Fig. 2: a schematic view of an embodiment of a meter according to the present invention;
- Fig. 3: a schematic view of an embodiment of an entity comprising an embodiment of a meter according to the present invention;
- Fig. 4: a schematic view of an embodiment of a peer-to-peer application according to the present invention;
- Fig. 5: a schematic view of an embodiment of a supply system according to the present invention;
- Fig. 6: a schematic view of a further embodiment of a supply system according to the present invention;
- Fig. 7: a diagram of an embodiment of a method according to the present invention,
- Fig. 8: a diagram of a further embodiment of a method according to the present invention,
- Fig. 9: a diagram of a further embodiment of a method according to the present invention,
- Fig. 10: a diagram of a further embodiment of a method according to the present invention, and
- Fig. 11: a diagram of a further embodiment of a method according to the present invention.

Like reference numerals in different figures indicate like elements.

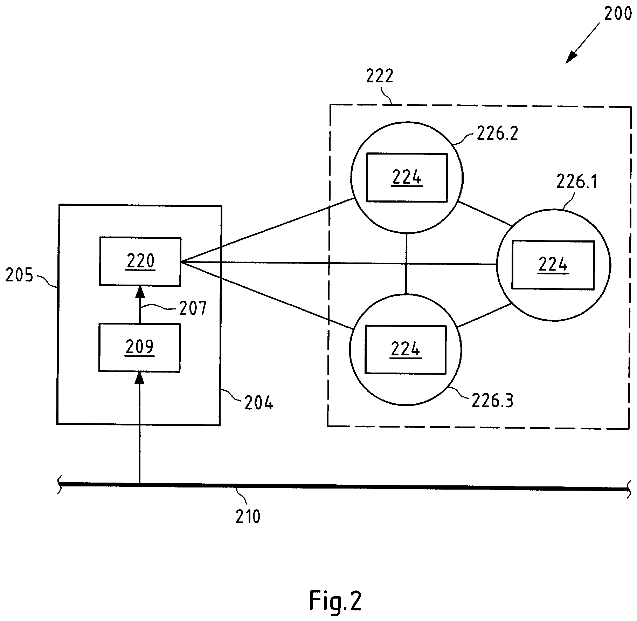

Figure 2 shows a schematic view of an embodiment of a meter 204 according to the present invention. The depicted meter 204 is integrated in an embodiment of a system 200 of the present invention. The meter 204 comprises a housing 205. The housing 205 can be a secure housing 205. The secure or tamper-proof housing 205 is a housing 205 which at least prevents a (manual) manipulation of the meter 204.

In the housing 205, two modules 209 and 220 are integrated. In other words, the housing 205 encloses the modules 209 and 220. In particular, a first module 209 is a measuring module 209 arranged for measuring a quantity parameter of a supply medium flowing through supply channel 210. The supply channel 210, preferably a house connection 210, is configured to transport a supply medium, such as electric current, natural gas, water, etc. For instance, the supply channel 210 is a pipe 210 or an energy cable 210.

The measuring module 209 comprises means for measuring at least one quantity parameter. For instance, an electrical measuring module 209 can comprise means for measuring the current and/or power flowing through the electrical cable 210. The electrical measuring module 209 can (continuously) measure the instantaneous voltage (volts) and current (amperes) to give energy used or delivered.

Furthermore, a fluid measuring module 209, such as a water measuring module 209 or a gas measuring module 209, can be configured to measure the volumetric flow rate, i.e. the volume of fluid (e.g. gas or water) which passes the pipe 210 per unit time. A heat measuring unit 209 can be configured to measure the quantity of water, e.g. the volumetric flow rate, and the flow temperature and return flow temperature. Based on the difference of the measured temperatures and the quantity of water, the delivered or received energy amount can be determined by the heat measuring module 209. Also these measuring modules 209 can preferably measure the respective quantity parameters in a continuous way.

The measuring module 209 has a communication connection 207, such as a wired connection 207, to a peer-to-peer module 220. Preferably, the communication connection 207 is an unidirectional connection 207 from the measuring module 209 to the peer-to-peer module 220. The measuring module 209 transmits the measured data and e.g. meter status information to the peer-to-peer module 220. For instance, the data can be transmitted at predetermined time points or in a continuous manner.

A further difference between the embodiment of the figure 1 and the embodiment in figure 2 is that the system 200 does not comprise a central server. The present system comprises a peer-to-peer network 222, in particular, a computer-to-computer network. The peer-to-peer module 220 comprises an interface to the peer-to-peer network 222.

The peer-to-peer network 222 includes a plurality of nodes 226.1 to 226.3 and computers 226.1 to 226.3, respectively. A peer-to-peer network 222 is characterized herein by the fact that preferably each node and/or participant is connected to every other node and/or participants. In addition, the computers have equal rights, which distinguish them from a server-client structure. In other words, the peers are equally privileged. Thereby, peers of a cluster can be equally privileged.

The illustrated three nodes 226.1 to 226.3, for example, computers 226.1 to 226.3 comprise (in each case) a peer-to-peer application 224. As can be seen from figure 2, on each node 226.1 to 226.3 the same peer-to-peer application 224 is implemented. Preferably, the peer-to-peer application 224 may be a public register, which is in particular readable by all participants (not only the nodes) of the peer-to-peer network 222. Each node 226.1 to 226.3 comprises preferably the (entire) public register 224 or permissioned and/or private register 224. Also it may be provided that on one node only a part of the register is provided. In a particularly preferred embodiment the peer-to-peer application 224 may be a block chain 224.

Further, the peer-to-peer module 220 is adapted to communicate with the peer-to-peer network 222. In other words, peer-to-peer module 220 is at least a participant in the peer-to-peer network 222. Each participant of the peer-to-peer network 222 may know preferably all participants (e.g. the respective addresses) of the peer-to-peer network 222.

In the present case, the peer-to-peer module 220 is only configured to communicate with the peer-to-peer network 222. In other words, the peer-to-peer module 220 is only a participant (and not a node) of the peer-to-peer network 222. The peer-to-peer module 220 is configured to provide the measured quantity parameter to the peer-to-peer application 224. This enables the peer-to peer network 222 to check whether a previously generated supply medium transaction agreement between two entities has been fulfilled. For this purpose, a peer-to-peer module 220 can communicate with the peer-to-peer application 224 to cause the generation of a supply medium transaction agreement. Subsequently, in accordance with the generated agreement the supply medium, like electric current or electric power, water, such as fresh water or wastewater, gaseous media, such as natural gas or similar (combustible) gas, heat, for example in the form of hot air, and/or cold, are transmitted e.g. in the form of cold air. The actual exchanged quantity of supply medium is measured by the meter 204 and communicated to the peer-to-peer application 224 by the meter 204. Since measuring module 209 and peer-to-peer module 220 are integrated in the meter 204 in a tamper-proof manner, manipulations of the quantity parameters can be at least reduced. Further, the measured quantity parameters are checked by preferably the total peer-to-peer network.

An embodiment of a peer-to-peer application according to the invention and the operation of an embodiment of the meter and supply system are hereinafter explained in more detail.

For a better illustration, the following embodiments relate to a supply system in the form of an electrical power grid. However, the invention is not limited thereto. In particular, the following description can be transferred to other supply systems or networks, such as gas supply networks, water supply networks or district heating networks.

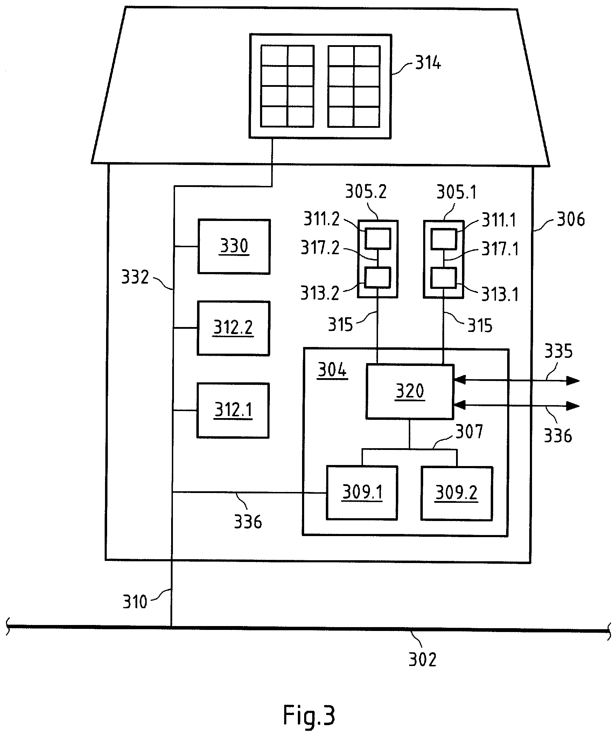

Figure 3 shows a schematic view of an embodiment of an entity 306 according to the present invention, wherein the entity 306 comprises an embodiment of a meter 304 according to the present invention.

The entity 306 may be a building 306 or household 306. The entity 306 is connected to a supply channel network 302 through a terminal 310 in form of a supply channel 310. The supply channel network 302 may be an electric power grid comprising electric power lines, transformers, etc.

Moreover, in the present embodiment, an internal electrical network 332 of entity 306 is connected via the connection 310 with the public or private power grid 302.

Exemplarily two electrical consumers 312.1, 312.2 are connected to the internal electrical network 332. Exemplary and non-exhaustive electrical consumers 312.1, 312.2 are refrigerators, lighting equipment, televisions, computers, washing machines, kitchen appliances, etc. It shall be understood that an entity 306 can comprise more than two electrical consumers.

In addition to the electrical loads 312.1, 312.2, in the present case the entity 306 comprises an electrical generator 314 in the form of a photovoltaic device 314. It shall be understood that alternatively or additionally other electrical generators, like a micro-CHP (combined heat and power), (small) wind turbines, etc., can be provided. The electrical power delivered by the generator 314 can be consumed by loads 312.1, 312.2, stored in an electrical energy storage device 330, such as a battery 330, and/or fed into the power grid 302.

As can be further seen, a meter 304 is connected to the electrical circuit 332. The meter can be preferably arranged at the house connection 310. The meter 304 comprises two measuring modules 309.1, 309.2 wherein each of the measuring modules 309.1, 309.2 can be configured to measure the amount of power received from the grid 302 and the amount of power fed into the grid 302.

The advantage of two measuring modules 309.1, 309.2 is, in particular, that the entity 306 can generate a (fundamental) supply medium transaction agreement with a central authority, such as a central server of a network operator, and individual supply medium transaction agreements with other entities by means of the peer-to-peer module and the peer-to-peer network. To be able to uniquely assign the respective power flow or current flow to a particular supply medium transaction agreement, a first measuring module 309.1 can, for example, measure the total amount and the at least one further measuring module 309.2 can measure the amount of flowing power during periods for which individual supply medium transaction agreements have been made. Then, by computing operations a clear assignment of a delivered or received and measured amount of power can be assigned to the different supply medium transaction agreements.

It shall be understood that further meters may be provided to individually determine, for example, the consumption of particular consumers or the power produced by a particular generator.

The meter 306 also includes a peer-to-peer module 320. The peer-to-peer module 320 may be, for example, at least a part of a computing device, such as a computer. In particular, the peer-to-peer module 320 can be at least partially formed by a software module and/or at least partially formed by hardware module.

The peer-to-peer module 320 has, in particular, a communication interface to communicate with the peer-to-peer network via a communication link 336 (bidirectional). Further, the peer-to-peer module 320 comprising a processing unit is at least configured to generate compatible peer-to-peer application messages. Moreover, the peer-to-peer module 320 has at least one further data input. In particular, the peer-to-peer module 320 has a communication connection 307 to the respective measuring modules 309.1, 309.2. Furthermore, data can be received via a communication network 335, wherein the data can be provided by external data sources, such as weather data sources, etc. The peer-to-peer module 320 may have further interfaces to other devices. In particular, user interfaces, such as a screen and/or input means may be provided with the meter 304.. In addition, a (not depicted) home automation controller can be provided. The home automation controller can be configured to communicate with the peer-to-peer application. The home automation controller can comprise further interfaces to other devices, such as display devices, configured to visualize at least the meter data of meter 304 preferably received via the peer-to-peer application. A more detailed description of the operation of the peer-to-peer module 320 is carried out subsequently.

It shall also be noted that in an advantageous embodiment data, such as weather forecasts and/or market data, can be made available to each peer by a so-called feed of the peer-to-peer application. For example, the participants of a peer-to-peer network may have agreed on one or more weather information provider. In this case, the at least one weather data source can transmit weather forecast data to the peer-to-peer application. The weather source may have been validated by at least one part of the peers of the peer-to-peer network. Preferably, for each participant the same weather information is available by means of the peer-to-peer application.

Optionally, the entity 306 can comprise at least one further meter 305.1, 30.5.2. In the present embodiment, two further meters 305.1, 30.5.2 are provided. It shall be understood that in other variants, there might be three or more further meters or only one further meter.

The further meters 305.1, 305.2 can also be denoted as secondary meters 305.1, 30.5.2 while the meter 304 can be denoted as the primary meter 304. As can be seen, the secondary meters 305.1, 305.2 are each connected with the primary meter 304 by a secure and wired connection 315. In particular, each secondary meter 305.1, 305.2 can comprise a communication module 313.1, 313.2 connectable to the peer-to-peer module 320 via connection 315. Furthermore, each secondary meter 305.1, 305.2 can comprise at least one measuring module 311.1, 311.2. Each of the measuring modules 311.1, 311.2 is connectable to the respective communication module 313.1, 313.2 via a secure connection 317.1, 317.2.

By way of example, the first secondary meter 305.1 can be a gas meter. In order to provide the measured gas values (e.g. the consumed gas amount) to a respective peer-to-peer application of a respective peer-to-peer network (which might be another or the same peer-to-peer network than/as the peer-to-peer network for handling the meter data of meter 304) the further meter data are transmitted by the communication module to the respective peer-to-peer application via the peer-to-peer module 320 of the primary meter 304. The peer-to-peer module 320 can comprise an additional decentral application configured to provide the respective data via an API to the respective peer-to-peer application. The second secondary meter 305.2 can be a water meter 305.2. The functioning of the secondary meter 305.2 is similar to the already described functioning of the first secondary meter 305.1.

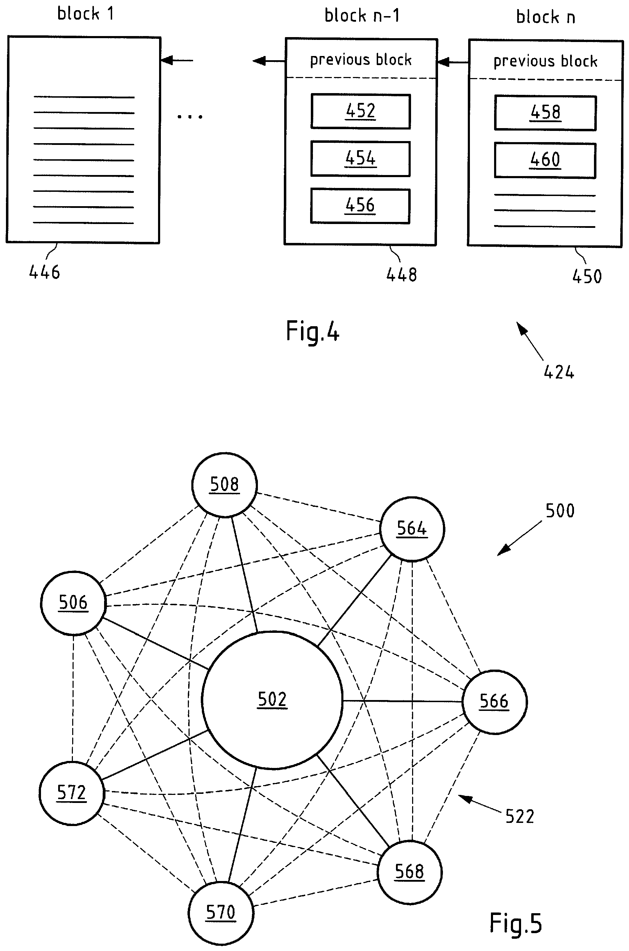

Furthermore, figure 4 shows a schematic view of an embodiment of a peer-to-peer application 424 according to the present invention. The peer-to-peer application 424 is a register readable in particular by the participants of the peer-to-peer network 424. Thereby, messages can be written and/or read into/from the register by a peer-to-peer module of a meter, an entity and/or any other participants in the peer-to-peer network. In a preferred embodiment, the peer-to-peer application 424 may be a block chain 424.

Hereinafter, it is assumed in the following description of the present embodiment that the peer-to-peer application 424 is a block chain 424. However, the following remarks can be easily transferred to other peer-to-peer applications.

The block chain 424 is formed by at least one block 446 to 450, preferably by a plurality of interconnected blocks 446 to 450. The first block 446 may also be called genesis block 446. As can be seen, a block 448, 450 (except for the first block) refers to each previous block 446, 448. A new block can be created by a computationally intensive process (for example, so-called "mining" or through another appropriate process) and will be particularly provided to all participants of the peer-to-peer network.

The present block chain 424 is particularly adapted to receive messages from a peer-to-peer module of a meter or from another peer-to-peer device of another participant of the peer-to-peer network and to save this message in the block chain 424. In particular, a new message in the current block 450 of the block chain 424 can be saved and published. Due to the configuration of a block chain 424 as a public register 424, the message of peer-to-peer module of a meter can be read by preferably all participants of the peer-to-peer network.

In the present block chain 424 different types of messages, for example, within a smart contract (algorithm and/or storage at the block chain) can be processed and/or stored. Preferably, the message 452 comprises the quantity of a supply medium, such as electrical power, consumed or delivered by an entity and measured by a meter of the entity per time unit.

Another message 454 can be a request message 454. A request message 454 is characterized in that it can include the following data:

| | |
|---|---|
| Quantity specification: | amount of supply medium, which is desired by an entity or made available |
| Time indication: | future period, at which the desired supply amount is desired or provided |
| Transaction criterion: | criterion that must be met by another entity to complete a supply medium transaction agreement about the specified amount and period |

It shall be understood that other transaction criteria can be defined. More information can be, for example, a time stamp, a signature of the sender of the message, a message ID of the transaction and other criteria, such as an indication of the desired production or consumption type, distance to the entity, meter status information, etc.

Another message 456 may be an acceptance message 456. An acceptance message 456 may comprise identical or at least similar data details as compared with a request message 454. Additionally, the acceptance message 456 can comprise a reference indication to a previous request, such as the ID of the request message 454. For example, it can be listed in an acceptance message 456 in relation to a request message 454 that a certain and desired amount of supply medium can be delivered for the future period in accordance with the transaction criterion. The amount may be a sub-amount of the requested quantity. The specified time may also be a part-time or sub-time. It can also be given a lower/higher transaction criterion.

If an acceptance message 456 includes only a sub-quantity of the requested quantity, a part-time indication and/or a lower, higher or other transaction criterion, the acceptance message 456 can be called a counter-offer message. This can be accepted by the first entity through an acceptance message. Based on this, the entity, e.g. the peer-to-peer module, may cause the generation of a supply medium transaction agreement.

In particular, there can be multiple request messages and/or accepting messages and/or messages comprising a delivered/consumed quantity parameter of a supply medium of a particular period. Each entity of a meter can give guidelines, according to which at least one supply medium transaction agreement can be generated. In a preferably automated, such as iterative process, each request message can be associated to an optimally corresponding acceptance message. The block chain 424 may also be configured to generate, based on the messages of a peer-to-peer module, a supply medium transaction agreement 458.

A supply medium transaction agreement 458 may be stored within a smart contract 458 in a block 450. A smart contract 458 may comprise computer program code. In the supply medium transaction agreement 458, in particular, the exchange or the delivery or receipt of a certain amount of supply medium for a certain time period and/or a transaction criterion as a given price, can be agreed between a first entity comprising a meter and another entity comprising a meter. For example, the first entity can cause the other entity by means of the block chain 424 to generate an agreement that the first entity supplies a certain amount X of electrical power for a period Tx (X kW/Tx h) to the other entity via the mains. Corresponding supply medium transaction agreements may be generated in other supply systems.

During the time Tx, the meters of the involved entities measures the power flow and transmits the actual exchanged amount X of power of the period Tx to the block chain 452, which saves the messages 454, e.g. X kW /Tx h (and additional data, such as transaction ID, entity ID, and the like). Preferably, each of the involved entities transmits the respective data via their associated meters to the block chain. The meter data stored in the block chain 424 can then be checked and verified by the peer-to-peer network, in particular, the participants of the peer-to-peer network.

After a positive verification of the meter data, an agreed transaction criterion transaction 460 can be generated and performed by means of the block chain 424. For instance, an agreed amount of a crypto currency can be transferred. Also this can be verified by the peer-to-peer network, in particular, the participants of the peer-to-peer network.

In particular, the peer-to-peer application 424 is configured to save the messages 452 to 460 in a tamper-proof manner. This is done essentially by the fact that through the entire peer-to-peer network, for example, a supply medium transaction agreement can be verified by the cumulative calculation power of the entire peer-to-peer network.

Preferably, at least the above-described messages, such as the supply medium transaction agreements and meter data messages, can be hashed together in pairs in a block of the block chain by a Merkle tree. In particular, only the last hash value, the so-called root hash, is noted as a checksum in the header of a block. Then, the block can be coupled with the previous block. Chaining of the blocks can be performed using this root hashes. Each block can include the hash of the entire previous block header in its header. This makes it possible to clearly define the order of the blocks. In addition, this may also prevent the subsequent modification of previous blocks and the messages stored in the previous blocks, since in particular the hashes of all subsequent blocks would have to be recalculated in a short time.

In the figure 5 a schematic view of another embodiment of a supply system 500, in particular an electrical supply system 500, is shown. The illustrated supply system 500 comprises seven entities 506, 508, 564 to 572. All entities 506, 508, 564 to 572 are connected or at least connectable to a supply channel network 502, in particular a power grid 502. In the present example, each entity 506, 508, 564 to 572 can comprise a meter, as described hereinbefore.

As can be further seen, the entities 506, 508, 564 to 572 and their respective (not shown) peer-to-peer modules of their meters form a peer-to-peer network 522 comprising a (not shown) peer-to-peer application, for example, the block chain 424 according to figure 4.

The first entity 506 may be a household 506, which comprises a plurality of electrical consumers. The first entity 506 may therefore be referred to as electrical consumer 506. The first entity 506 therefore has a need for the supply medium and may generate appropriate request and/or acceptance messages and transmit these messages to the peer-to-peer network 522. In addition, the entity 506 comprises a meter, as described above.

The further entity 508 may also be a household 508, in particular a prosumer 508. As a prosumer 508 the further entity 508 can deliver power to the power grid 502 and can also receive power from the power grid 502. The prosumer 508 can generate appropriate request and/or accepting messages and/or meter data by its meter and sent these messages to the peer-to-peer network 522.

The further entity 564 may be a decentral producer 564, such as a cogeneration unit 564. In other words, the entity 564 is adapted to feed power into the grid 502. This entity 564 might also comprise a meter and the meter can generate appropriate messages, as well as the following entities can comprise a meter as described above for generating appropriate messages.

Moreover, as an entity 566, an electrical storage 566 may be provided, such as a battery 566. The storage 566 may in particular be configured to temporarily store over power (due to excess capacity in the electricity grid 502) and to deliver again this power in the case of a power requirement. Further, an entity 568 may be an electrically powered machine 568, e.g. a (smart) electrical consumer 568, such as an IoT device. The entity 570 may be, for example, a company 570 with a variety of electrical consumers and/or with one or more producers. Finally, as an entity 572 a balancing entity 572 is provided, which will be explained in more detail below.

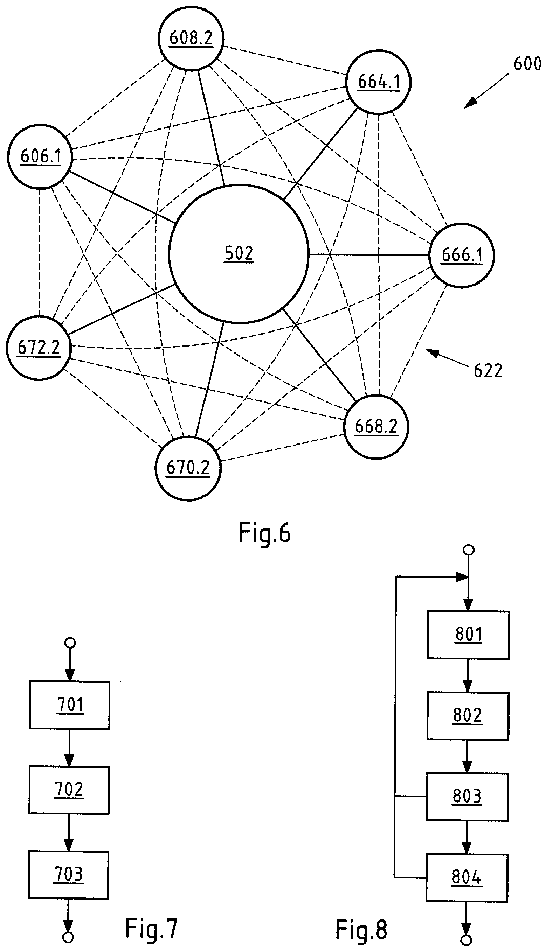

Figure 6 shows a schematic view of another embodiment of a supply system 600, in particular, an electrical supply system 600. Hereinafter, only the differences of the supply system 600 compared to the supply system 500 of Figure 5 will be described. It should be noted that as entities 606.1 to 672.2 there may be provided the same, similar or other entities compared to the entities described above.

Unlike the previous example, two different types of peers or node computers 606.1, 664.1, 666.1 or 608.2, 668.2, 670.2 and 672.2 are presently illustrated. All peers 606.1 to 672.2 are comprised by the peer-to-peer network 622. In the present embodiment, however, only part of the peers 604.1 to 672.2, in the present case, the peers 604.1, 664.1, 666.1, check the validity of the data stored in the peer-to-peer application messages, such as the meter data or the supply medium transaction agreements. Furthermore, only a part of the entire peers can be configured to store the peer-to-peer application and/or only a part of the peers can be configured to execute the algorithms of a smart contract. Since the validation/verification of e.g. meter data requires a considerable computational effort, it may be advantageous for reasons of efficiency, if only a part of the peers 604.1, 664.1, 666.1, especially particularly powerful peers 604.1, 664.1, 666.1, perform the validation. Validation can be done on-chain or off-chain. Off-chain validation can be managed by the peer-to-peer application, like the code on the block chain. Powerful means in particular a high computing power. In other words, in the present case a valid entry in the peer-to-peer application, such as a block chain, is assumed if (only) a part of the peers 604.1, 664.1, 666.1 comes to a positive result. It shall be understood that only a single, especially particularly powerful peer can perform the validation process.

Similarly, in an alternative (not shown) embodiment a particularly large peer-to-peer network may be divided in two or more clusters. In a corresponding peer-to-peer network, for example, a validation will only be carried out by the members of one cluster.

Figure 7 shows an embodiment of a method according to the present invention. In a first step 701, at least one quantity parameter of a supply medium flowing through a supply channel, such as a house connection, is measured by a measuring module. The measuring module can be integrated in a meter. Preferably, the quantity parameter can be continuously measured.

The measured supply medium quantity parameter can be transmitted from the measuring module to the peer-to-peer module via a communication connection arranged between the measuring module and the peer-to-peer module in step 702. For instance, in order to reduce the data amount, the measuring module can be configured to accumulate the measured supply medium quantity for a particular time unit, such as 1 sec, 1 min, 15 min, 1 h, 1 day. Then, the measuring module can transmit the accumulated supply medium quantity for the particular time unit in form of a supply medium quantity parameter (e.g. X kw/15 min) to the peer-to-peer module.

Thereby, the peer-to-peer module as well as the communication connection is also integrated in the meter.

In a next step 703, the measured quantity parameter is provided to a peer-to-peer application of a peer-to-peer network by the peer-to-peer module. This can be performed, as explained hereinbefore.

In the following figures, additional procedures are described which can be at least partially performed or triggered by a meter according to the present invention.

Figure 8 shows a flow diagram of a method which can be in particular performed by a peer-to-peer application, such as the chain block 424 according to the figure 4.

In a first step 801, the peer-to-peer application receives a message, which refers to an exchange of a supply medium. Exemplary messages include meter data messages, request or acceptance messages, supply medium transaction agreement messages, transaction criterion transaction messages, etc. These are then reviewed by at least one part of the peers of a peer-to-peer network for plausibility, such as has been previously described.

In a next step 802 the received message is stored by the peer-to-peer application. Due to the special configuration of the peer-to-peer application and the peer-to-peer network, each participant can in particular read the message. In particular, only each authorized participants can read the messages. Then, the peer-to-peer network can verify the data of the message by the cumulative calculation power of preferably the entire peer-to-peer network (step 803). In the event that more messages can be written into the block, the process continues with step 801. In the event that no more messages can be written into the current block, the process continues with step 804. In step 804, a new block can be generated which can be chained to the previous block e.g. by a hash function. Then it can be continued to step 801.

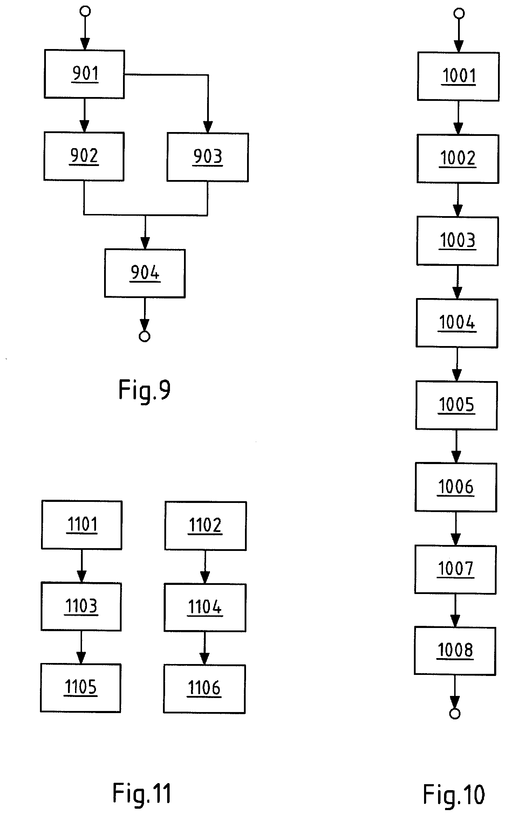

Figure 9 shows another flow diagram of an embodiment of a method that can be performed by a meter comprising a peer-to-peer module, wherein the meter can be associated with a particular entity.

In a first step 901, a supply medium plan of the entity associated with the meter is provided for a future period. For example, an appropriate supply medium plan can be created by the peer-to-peer module of the meter or received from another device of the entity, such as a home automation controller of a home automation system of the entity.

The creation of a supply medium plan can be based on historical data, user input and/or forecast data, such as weather data, market data, personal information, such as calendar data. For example, the measuring module of the at least one meter can transmit the measured quantity parameters to the peer-to-peer module. The peer-to-peer module can either create a supply medium plan on its own or transmit the measured quantity parameters to a further device, such as the home automation controller. An entity might comprise a plurality of meters wherein the respective quantity parameters can be processed by a main meter or another device, such as the home automation controller. In the following, it is assumed that the peer-to-peer module of the meter creates the plan.

The peer-to-peer module comprises processing means adapted to store the received quantity parameter in a memory unit. The quantity parameters can be particularly provided with a time stamp. For example, the measured consumption and/or production parameters can be provided with a date and/or time (period). Hereby, a course of the energy consumption/generation can be created. This history can then be used to generate the supply medium plan.

In particular, from this historical data and preferably additional forecast data, such as weather data, and/or user information, such as absenteeism, the supply medium plan for a future period, such as the next week, the next day, the next hour, etc., is created.

Preferably, a supply medium plan can be created the day before for the next day, wherein the supply medium plan can be divided in a plurality of sub-areas (e.g. 15 min periods, i.e. 96 sub-areas).

In addition to the supply medium plan at least one transaction criterion can be especially specified for each sub-area. For example, two or more transaction criteria per sub-area can be specified, wherein the criteria can be a maximum and a minimum criterion, such as a maximum price and a minimum price. Such a specified range has the advantage that it can be flexible and simultaneously optimally respond to the request messages of another entity. The best offer from the perspective of the entity based on the self-imposed criteria can be determined and selected in particular in an automated, iterative process. Further transaction criteria can be specified such as the kind of producer, local proximity to the entity, etc.

Depending on the above parameters, a request message is preferably generated for each sub-area by the peer-to-peer module of the meter and transmitted to the peer-to-peer network in step 902. Alternatively or additionally, in step 903, the peer-to-peer module can read a request message of another entity stored in the peer-to-peer application and can generate and send an accepting message to such a request message based on the above parameters and the parameters of the read request message to the peer-to-peer network.

In a step 904 peer-to-peer module of the entity can effect generating a supply medium transaction agreement with another entity by means of peer-to-peer application, especially after an agreement with another entity. Preferably, a corresponding message from at least one of the entities can be transferred to the peer-to-peer network.

For verification of messages a public and/or private key can be used by the entities.

The described method of figure 9 can in particular be performed prior to sending meter data, as described in figure 7.

Figure 10 shows a further diagram of another method according to the present invention. The following procedure will be exemplified explained by means of the supply system 500 according to figure 5.

In step 1001, preferably each entity 506, 508, 564-570 can generate a supply medium plan and associated transaction criteria. This can be done as set out above.

In a next step 1002, at least one entity 506, 508, 564-570 can cause the generation of a supply medium transaction agreement. Prior to this step, request and accepting messages can be exchanged by the involved entities. In particular, a plurality of individual supply medium transaction agreements are generated between the entities 506, 508, 564-570 by means of the peer-to-peer application and the exchange of messages with the peer-to-peer application. It may occur that after the step 1002 some requests of entities 506, 508, 564-570 could not be met. For example, at least one entity 506, 508, 564-570 may have still a need for the supply medium in one or more time sub-area/s. Alternatively or additionally, at least one entity 506, 508, 564-570 may comprise an excess of supply medium to be generated in one or more (different) sub-area/s of the future. This can occur, for example, due to volatile generators, such as wind turbines or photovoltaic devices.

Then, in a step 1003 it can therefore be provided that the at least one entity 506, 508, 564-570, which has open at least one at least not completely fulfilled request message, can generate a supply medium transaction agreement with the balancing entity 572 by means of the peer-to-peer application. A balancing entity 572 may in particular be adapted to compensate at any time for a lack of supply medium quantity and/or for a remove of an excess of supply medium quantity. For example, the balancing entity 572 may be a utility company, such as a power company, etc. Alternatively and preferably, the balancing entity 572 may be a decentralized autonomous organization (DAO). In the present embodiment an electric power company with a plurality of, for example, conventional power plants and the possibility to forward power to entities that are not part of the peer-to-peer network 522 can be provided as the balancing entity 572. The balancing entity 572 therefore ensures particularly safe and stable operation of the power grid. Critical power states can be prevented. The capacity of the power system can be utilized optimally. Flexibilities can be better utilized.

As already described, preferably the supply medium transaction agreements are concluded/generated on the day before for the following day. Preferably, each entity 506, 508, 564-570 can perform a reconsideration of their own made prognosis/supply medium plan, in particular of individual sub-areas in a step 1004 at a later time point. For example, it may be provided that at least at one individually definable time point in front of a sub-area preferably each entity 504, 506, 564-570 verifies whether the planned demand/offer for this sub-area will actually be achieved. It shall be understood that after generating a supply medium transaction agreement an (almost) continuous monitoring can be carried out until the agreed start time.

If a deviation between a planned supply medium quantity and a currently forecasted supply medium amount for a particular sub-area is determined, for example due to weather changes and/or user actions, the entity 506, 508, 564-570, at step 905, can cause the generation of a further supply medium transaction agreement with another entity 506, 508, 564-570 by means of the peer-to-peer application. This is performed in particular due to the detected deviation. For example, if a producer and a consumer detect corresponding deviations, these entities may cause the generation of a corresponding supply medium transaction agreement. This allows ensuring the security of supply and/or grid stability in decentralized manner and, in particular, decentrally optimizing the use of decentralized plants and the network.

Here it should be noted that due to the inventive configuration of the peer-to-peer application, such as a block chain or decentral public ledger, a subsequent change a supply medium transaction agreement may not be possible, but a further supply medium transaction agreement can be generated if it is detected that a previous supply medium transaction agreement cannot be at least fully met.

In the event that in step 1005 requests of entities 506, 508, 564-570 could not be fulfilled, in step 1006, corresponding to step 1003, supply medium transaction agreement/s can be generated.

In the next step 1007, during the respective sub-areas set in a supply medium transaction agreement, preferably the respective meter of each entity 506, 508, 564-570 (continuously) considers whether the (currently measured) actual quantity parameter values of the supply medium meets the quantity parameter established in the supply medium transaction agreement. If a deviation is detected, for example, due to weather and/or market changes and/or user actions, in step 1008 this deviation can be compensated by (direct) generation of supply medium transaction agreements with other entities that have also detected a current deviation, and/or the deviation can be directly compensated by (direct) generation of supply medium transaction agreements with the balancing entity 572. A secure and stable operation of a supply network can be obtained decentrally.

Figure 11 shows another embodiment of a method according to the present invention. In particular, the method can be performed when the exchange of the supply medium has already taken place in accordance with a supply medium transaction agreement.

Preferably, a meter associated with a first entity, in particular, the measuring module of the meter, can measure the quantity/amount of power during the time period Tx. E.g., the measuring module can measure electric power received from the power grid (X kW / Tx h) at least during the period Tx. Preferably parallel to this, the meter of another entity, in particular, measuring module of the meter of the other entity, measures a delivered power during the time period Tx in a step 1102. In the respective steps 1101 and 1102, each measured power parameter (X kW / Tx h) is transmitted in form of a message to the peer-to-peer application by the respective peer-to-peer module.

In the next steps 1103 and 1104 it can be checked in each case by means of the peer-to-peer application, whether the supply medium quantity was exchanged in accordance with a supply medium transaction agreement between the first and the other entity. For example, the amounts of power measured by the respective meters of the entities can be reviewed and/ validated by at least a part of the peers of the peer-to-peer network. For instance, it can be checked whether the delivered and received power correspond to the agreed amount of power in the supply medium transaction agreement.

Depending on the check result, the first entity can transfer the entire (or only a part) of the agreed price in the form of crypto money in step 1105. In step 1106, the other entity receives the transferred crypto money. The steps 1105 and 1106 shall be carried out in accordance with previous statements by the peer-to-peer application, in particular, in a tamper-proof manner. Especially, a plausibility test as described above can be carried out by at least a portion of the peers.

Preferably, the entire peer-to-peer network can check by cumulative processing power, whether the measured power amounts are correct and/or the transfer has been carried out correctly, for example whether the first entity was in fact the owner of the crypto money or the like.

It can also be provided that a network operator retroactively informs the peer-to-peer network based on the meter data, for example, once a month, week, etc., on actually detected counts and performs a correction of the effectively exchanged supply medium quantity compared to the amounts reported in the peer-to-peer application. Also this correction can be carried out by means of peer-to-peer application and, for example, settled between the involved entities.

Generally, the present system has the ability to validate individual meter data by nodes in the P2P network which is the basis for a "trustless" model. No trust in a central authority is needed. Validation and e.g. optimization of the peer-to-peer application or peer-to-peer matching can be done on-chain or off-chain, as described hereinbefore. Off-chain means that the process is controlled by the block chain. The process itself can be performed by other devices, such as servers/cloud. The block chain can check whether e.g. in the case of a validation process a plurality of servers provides a positive result or a negative result.

## Claims

1. A meter (204, 304) of a supply system (200, 500, 600), comprising:
- at least one measuring module (209, 309.1, 309.2) configured to measure at least one quantity parameter of a supply medium flowing through a supply channel (210, 310);
**characterized in that**
- the meter (204, 304) comprises at least one peer-to-peer module (220, 320) configured to communicate with a peer-to-peer application (224, 424) of a peer-to-peer network (222, 522, 622),
- wherein the measuring module (209, 309.1, 309.2) is configured to provide the measured quantity parameter of the supply medium to the peer-to-peer module (220, 320) via a communication connection (207, 307) arranged between the measuring module (209, 309.1, 309.2) and the peer-to-peer module (220, 320),
- wherein the peer-to-peer module (220, 320) is configured to provide at least the measured quantity parameter to the peer-to-peer application (224, 424),
- wherein the meter (204, 304) is configured to be associated with an entity (306, 506, 508, 564, 566, 568, 570, 572, 606.1, 608.2, 664.1, 666.1, 668.2, 670.2, 672.2), and
- the peer-to-peer module (220, 320) is configured to generate at least one request message and/or at least one acceptance message based on a supply medium plan created for said entity (306, 506, 508, 564, 566, 568, 570, 572, 606.1, 608.2, 664.1, 666.1, 668.2, 670.2, 672.2) associated with the peer-to-peer module (220, 320) and to cause the generation of a supply medium transaction agreement.

2. The meter (204, 304) according to claim 1, **characterized in that**
- the meter (204, 304) comprises a tamper-proof housing (205), and
- the measuring module (209, 309.1, 309.2) and the peer-to-peer module (220, 320) are integrated in the housing (205).

3. The meter (204, 304) according to any one of the preceding claims,
**characterized in that**
- the communication connection (207, 307) between the measuring module (209, 309.1, 309.2) and the peer-to-peer module (220, 320) is a wired communication connection (207, 307), and/or
- the communication connection (207, 307) between the measuring module (209, 309.1, 309.2) and the peer-to-peer module (220, 320) is an unidirectional communication connection (207, 307) from the measuring module (209, 309.1, 309.2) to the peer-to-peer module (220, 320).

4. The meter (204, 304) according to any one of the preceding claims,
**characterized in that**
- the meter (204, 304) is associated with a first entity (306, 506, 606.1), and
- the peer-to-peer module (220, 320) is configured to cause a generation of a supply medium transaction agreement about the exchange of a supply medium between the first entity (306, 506, 606.1) and a further entity (508, 564, 566, 568, 570, 572, 608.2, 664.1, 666.1, 668.2, 670.2, 672.2) by the peer-to-peer application (224, 424).

5. The meter (204, 304) according to any one of the preceding claims,
**characterized in that**
- the peer-to-peer network (222, 522, 622) is formed by a plurality of computer nodes (226.1, 226.2, 226.3), and
- the peer-to-peer module (220, 320) is only configured to communicate with the plurality of computer nodes (226.1, 226.2, 226.3).

6. The meter (204, 304) according to any one of the preceding claims 1 to 5,
**characterized in that**
- the peer-to-peer network (222, 522, 622) is formed by a plurality of computer nodes (226.1, 226.2, 226.3), and
- the peer-to-peer module (220, 320) is one of the computer nodes.

7. The meter (204, 304) according to any one of the preceding claims,
**characterized in that**
- a request message comprises a supply medium quantity parameter, time period and/or at least one transaction criterion, and/or
- an acceptance message comprises a supply medium quantity parameter, time period, and/or at least one transaction criterion.

8. The meter (204, 304) according to any one of the preceding claims 5 to 7,
**characterized in that** the peer-to-peer module (220, 320) is configured to cause a generation of a transaction criterion transaction based on an transaction criterion specified in the supply medium transaction agreement and the measured quantity parameter.

9. The meter (204, 304) according to any one of the preceding claims,
**characterized in that** the peer-to-peer module (220, 320) is further configured to communicate with at least one further meter (305.1, 305.2) via a wired connection (315) or wireless connection.

10. A supply system (200, 500, 600), comprising:
- at least one meter (204, 304) according to any one of the preceding claims,
- at least one supply channel (210, 310) configured to transport at least one supply medium,
- at least one peer-to-peer network (222, 522, 622) configured to provide a peer-to-peer application (224, 424), and
- wherein at least a subset of the computer nodes (226.1, 226.2, 226.3) of the peer-to-peer network (222, 522, 622) is configured to monitor the correctness of the provided quantity parameter.

11. The supply system (200, 500, 600) according to claim 10, **characterized in that**
- the peer-to-peer application (224, 424) is a decentralized register (224, 424), and
- the decentralized register (224, 424) is readable at least by a part of the participants of the peer-to-peer network (222, 522, 622).

12. The supply system (200, 500, 600) according to claim 10 or 11, **characterized in that** the peer-to-peer application (224, 424) comprises encryption means and/or signature means and/or verification means, wherein at least one of the encryption means and/or signature means and/or verification means is configured to store at least the provided quantity parameter.

13. The supply system (200, 500, 600) according to any of the preceding claims 10 to 12, **characterized in that** the peer-to-peer application (224,424) is a blockchain (224, 424) or decentral ledger (224, 424) comprising at least two blocks (446, 448, 450) coupled to each other.

14. The supply system (200, 500, 600) according to any of the preceding claims 10 to 13, **characterized in that** the supply system (200, 500, 600) comprises a further meter (305.1, 305.2) having at least one communication module (313.1, 313.2) configured to communicate with the peer-to-peer module (220, 320) via a wired connection (315) or wireless connection.

15. A method for operating a meter (204, 304) of a supply system (200, 500, 600), in particular, a meter (204, 304) according to any of the preceding claims 1 to 11, wherein the meter (204, 304) comprises at least one measuring module (209, 309.1, 309.2) and at least one peer-to-peer module (220, 320), the method comprising:
- measuring at least one quantity parameter of a supply medium by the measuring module (209, 309.1, 309.2),
- transmitting the at least one quantity parameter from the measuring module (209, 309.1, 309,2) to the peer-to-peer module (220, 320) via a communication connection (207, 307) arranged between the measuring module (209, 309.1, 309.2) and the peer-to-peer module (220, 320),
- providing at least the measured quantity parameter to a peer-to-peer application (224, 424) of a peer-to-peer network (222, 522, 622) by the peer-to-peer module (220, 320),
- wherein the meter (204, 304) is associated with an entity (306, 506, 508, 564, 566, 568, 570, 572, 606.1, 608.2, 664.1, 666.1, 668.2, 670.2, 672.2), and
- generating at least one request message and/or at least one acceptance message by the peer-to-peer module (220, 320) based on a supply medium plan created for said entity (306, 506, 508, 564, 566, 568, 570, 572, 606.1, 608.2, 664.1, 666,1, 668.2, 670.2, 672.2) associated with the peer-to-peer module (220, 320) and causing the generation of a supply medium transaction agreement.

## Patentansprüche

1. Zähler (204, 304) eines Versorgungssystems (200, 500, 600), umfassend:
- mindestens ein Messmodul (209, 309.1, 309.2), eingerichtet zum Messen mindestens eines Mengenparameters eines durch einen Versorgungskanal (210, 310) strömenden Versorgungsmediums;
**dadurch gekennzeichnet, dass**
- der Zähler (204, 304) mindestens ein Peer-to-Peer-Modul (220, 320) umfasst, eingerichtet zum Kommunizieren mit einer Peer-to-Peer-Anwendung (224, 424) eines Peer-to-Peer-Netzwerks (222, 522, 622),
- wobei das Messmodul (209, 309.1, 309.2) eingerichtet ist zum Bereitstellen des gemessenen Mengenparameter des Versorgungsmediums dem Peer-to-Peer-Modul (220, 320) über eine zwischen dem Messmodul (209, 309.1, 309.2) und dem Peer-to-Peer-Modul (220, 320) angeordnete Kommunikationsverbindung (207, 307),
- wobei das Peer-to-Peer-Modul (220, 320) eingerichtet ist zum Bereitstellen zumindest des gemessenen Mengenparameters der Peer-to-Peer-Anwendung (224, 424),
- wobei der Zähler (204, 304) eingerichtet ist zum zugeordnet sein zu einer Entität (306, 506, 508, 508, 564, 566, 568, 570, 572, 606.1, 608.2, 664.1, 666.1, 668.2, 670.2, 670.2, 672.2), und
- das Peer-to-Peer-Modul (220, 320) eingerichtet ist, zum Generieren mindestens einer Anforderungsnachricht und/oder mindestens einer Akzeptanznachricht basierend auf einem für die Entität (306, 506, 508, 508, 564, 566, 568, 570, 572, 606.1, 608.2, 664.1, 666.1, 668.2, 670.2, 670.2, 672.2) erstellten Versorgungsplan, die dem Peer-to-Peer-Modul (220, 320) zugeordnet ist und zum Bewirken einer Generierung einer Versorgungsmedium-Transaktionsvereinbarung.

2. Zähler (204, 304) nach Anspruch 1, **dadurch gekennzeichnet, dass**
- der Zähler (204, 304) ein manipulationssicheres Gehäuse (205) umfasst, und
- das Messmodul (209, 309.1, 309.2) und das Peer-to-Peer-Modul (220, 320) in dem Gehäuse (205) integriert sind.

3. Zähler (204, 304) nach einem der vorhergehenden Ansprüche, **dadurch gekennzeichnet, dass**
- die Kommunikationsverbindung (207, 307) zwischen dem Messmodul (209, 309.1, 309.2) und dem Peer-to-Peer-Modul (220, 320) eine drahtgebundene Kommunikationsverbindung (207, 307) ist, und/oder
- die Kommunikationsverbindung (207, 307) zwischen dem Messmodul (209, 309.1, 309.2) und dem Peer-to-Peer-Modul (220, 320) eine unidirektionale Kommunikationsverbindung (207, 307) von dem Messmodul (209, 309.1, 309.2) zu dem Peer-to-Peer-Modul (220, 320) ist.

4. Zähler (204, 304) nach einem der vorhergehenden Ansprüche, **dadurch gekennzeichnet, dass**
- der Zähler (204, 304) einer ersten Entität (306, 506, 606.1) zugeordnet ist, und
- das Peer-to-Peer-Modul (220, 320) eingerichtet ist zum Bewirken einer Generierung einer Versorgungsmedium-Transaktionsvereinbarung über den Austausch eines Versorgungsmediums zwischen der ersten Entität (306, 506, 606, 606.1) und einer weiteren Entität (508, 564, 566, 566, 568, 570, 572, 608.2, 664.1, 666.1, 668.2, 670.2, 672.2) durch die Peer-to-Peer-Anwendung (224, 424).

5. Zähler (204, 304) nach einem der vorhergehenden Ansprüche, **dadurch gekennzeichnet, dass**
- das Peer-to-Peer-Netzwerk (222, 522, 622) durch eine Mehrzahl von Computerknoten (226.1, 226.2, 226.3) gebildet ist, und
- das Peer-to-Peer-Modul (220, 320) nur eingerichtet ist zum Kommunizieren mit der Vielzahl von Computerknoten (226.1, 226.2, 226.2, 226.3).

6. Zähler (204, 304) nach einem der vorhergehenden Ansprüche 1 bis 5, **dadurch gekennzeichnet, dass**
- das Peer-to-Peer-Netzwerk (222, 522, 622) durch eine Mehrzahl von Computerknoten (226.1, 226.2, 226.3) gebildet ist, und
- das Peer-to-Peer-Modul (220, 320) einer der Computerknoten ist.

7. Zähler (204, 304) nach einem der vorhergehenden Ansprüche, **dadurch gekennzeichnet, dass**
- eine Anforderungsnachricht einen Versorgungsmengenparameter, einen Zeitraum und/oder mindestens ein Transaktionskriterium umfasst, und/oder
- eine Akzeptanznachricht einen Versorgungsmengenparameter, einen Zeitraum und/oder mindestens ein Transaktionskriterium umfasst.

8. Zähler (204, 304) nach einem der vorhergehenden Ansprüche 5 bis 7, **dadurch gekennzeichnet, dass** das Peer-to-Peer-Modul (220, 320) eingerichtet ist zum Bewirken einer Generierung einer Transaktion mit Transaktionskriterien basierend auf einem in der Versorgungsmedium-Transaktionsvereinbarung angegebenen Transaktionskriterium und dem Messmengenparameter zu bewirken.

9. Zähler (204, 304) nach einem der vorhergehenden Ansprüche, **dadurch gekennzeichnet, dass** das Peer-to-Peer-Modul (220, 320) ferner eingerichtet ist zum Kommunizieren mit mindestens einem weiteren Zähler (305.1, 305.2) über eine drahtgebundene Verbindung (315) oder eine drahtlose Verbindung.

10. Versorgungssystem (200, 500, 600), umfassend:
- mindestens einen Zähler (204, 304) gemäß einem der vorhergehenden Ansprüche,
- mindestens einen Versorgungskanal (210, 310) eingerichtet zum Transportieren mindestens eines Versorgungsmediums,
- mindestens ein Peer-to-Peer-Netzwerk (222, 522, 622) eingerichtet zum Bereitstellen einer Peer-to-Peer-Anwendung (224, 424), und
- wobei mindestens eine Teilmenge der Computerknoten (226.1, 226.2, 226.3) des Peer-to-Peer-Netzwerks (222, 522, 622) eingerichtet ist zum Überwachen der Richtigkeit des bereitgestellten Mengenparameters.

11. Versorgungssystem (200, 500, 600) nach Anspruch 10, **dadurch gekennzeichnet, dass**
- die Peer-to-Peer-Anwendung (224, 424) ein dezentrales Register (224, 424) ist, und
- das dezentrale Register (224, 424) von zumindest einem Teil der Teilnehmer des Peer-to-Peer-Netzwerks (222, 522, 622) lesbar ist.

12. Versorgungssystem (200, 500, 600) nach Anspruch 10 oder 11, **dadurch gekennzeichnet, dass** die Peer-to-Peer-Anwendung (224, 424) Verschlüsselungsmittel und/oder Signaturmittel und/oder Verifikationsmittel umfasst, wobei mindestens eines der Verschlüsselungsmittel und/oder Signaturmittel und/oder Verifikationsmittel eingerichtet ist zum Speichern zumindest des bereitgestellten Mengenparameters.

13. Versorgungssystem (200, 500, 600) nach einem der vorhergehenden Ansprüche 10 bis 12, **dadurch gekennzeichnet, dass** die Peer-to-Peer-Anwendung (224, 424) eine Blockchain (224, 424) oder ein dezentrales Ledger (224, 424) ist, die/das mindestens zwei miteinander gekoppelte Blöcke (446, 448, 450) umfasst.

14. Versorgungssystem (200, 500, 600) nach einem der vorhergehenden Ansprüche 10 bis 13, **dadurch gekennzeichnet, dass** das Versorgungssystem (200, 500, 600) einen weiteren Zähler (305.1, 305.2) mit mindestens einem Kommunikationsmodul (313.1, 313.2) umfasst eingerichtet ist zum Kommunizieren mit dem Peer-to-Peer-Modul (220, 320) über eine drahtgebundene Verbindung (315) oder drahtlose Verbindung.

15. Verfahren zum Betreiben eines Zählers (204, 304) eines Versorgungssystems (200, 500, 600), insbesondere eines Zählers (204, 304) nach einem der vorhergehenden Ansprüche 1 bis 11, wobei der Zähler (204, 304) mindestens ein Messmodul (209, 309.1, 309.2) und mindestens ein Peer-to-Peer-Modul (220, 320) umfasst, wobei das Verfahren umfasst:
- Messen mindestens eines Mengenparameters eines Versorgungsmediums durch das Messmodul (209, 309.1, 309.2),
- Übertragen des mindestens einen Mengenparameters vom Messmodul (209, 309.1, 309.2) an das Peer-to-Peer-Modul (220, 320) über eine zwischen dem Messmodul (209, 309.1, 309.2) und dem Peer-to-Peer-Modul (220, 320) angeordnete Kommunikationsverbindung (207, 307),
- Bereitstellen zumindest des Mengenparameters einer Peer-to-Peer-Anwendung (224, 424) eines Peer-to-Peer-Netzwerks (222, 522, 622) durch das Peer-to-Peer-Modul (220, 320),
- wobei der Zähler (204, 304) einer Entität (306, 506, 508, 508, 564, 566, 568, 570, 572, 606.1, 608.2, 664.1, 666.1, 668.2, 670.2, 670.2, 672.2) zugeordnet ist, und
- Generieren mindestens einer Anforderungsnachricht und/oder mindestens einer Akzeptanznachricht durch das Peer-to-Peer-Modul (220, 320) basierend auf einem für die Entität (306, 506, 508, 508, 564, 566, 568, 570, 572, 606.1, 608.2, 664.1, 666.1, 666.1, 668.2, 670.2, 670.2, 672.2) erstellten Versorgungsplan, die dem Peer-to-Peer-Modul (220, 320) zugeordnet ist, und Bewirken einer Generierung einer Versorgungsmedium-Transaktionsvereinbarung.

## Revendications

1. Appareil de mesure (204, 304) d'un système d'alimentation (200, 500 600), ledit appareil de mesure comprenant :
- au moins un module de mesure (209, 309.1, 309.2) configuré pour mesurer au moins un paramètre de quantité d'un milieu d'alimentation circulant à travers un conduit d'alimentation (210, 310) ;
**caractérisé**
- **en ce que** l'appareil de mesure (204, 304) comprend au moins un module de pair à pair (220, 320) configuré pour communiquer avec une application de pair à pair (224, 424) d'un réseau de pair à pair (222, 522, 622),
- appareil de mesure dans lequel le module de mesure (209, 309.1, 309.2) est configuré pour fournir le paramètre de quantité - mesuré - du milieu d'alimentation, au module de pair à pair (220, 320) via une connexion de communication (207, 307) agencée entre le module de mesure (209, 309.1, 309.2) et le module de pair à pair (220, 320),
- appareil de mesure dans lequel le module de pair à pair (220, 320) est configuré pour fournir au moins le paramètre de quantité ayant été mesuré, à l'application de pair à pair (224, 424),
- où l'appareil de mesure (204, 304) est configuré pour être associé à une entité (306, 506, 508, 564, 566, 568, 570, 572, 606.1, 608.2, 664.1, 666.1, 668.2, 670.2, 672.2), et
- le module de pair à pair (220, 320) est configuré pour générer au moins un message de demande et/ou au moins un message de réception, ledit message étant basé sur un plan concernant le milieu d'alimentation, ledit plan étant créé pour ladite entité (306, 506, 508, 564, 566, 568, 570, 572, 606.1, 608.2, 664.1, 666.1, 668.2, 670.2, 672.2) associée au module de pair à pair (220, 320), et configuré pour déclencher l'élaboration d'un accord de transaction concernant le milieu d'alimentation.

2. Appareil de mesure (204, 304) selon la revendication 1,
**caractérisé**
- **en ce que** l'appareil de mesure (204, 304) comprend un boîtier inviolable (205), et
- **en ce que** le module de mesure (209, 309.1, 309.2) et le module de pair à pair (220, 320) sont intégrés dans le boîtier (205).

3. Appareil de mesure (204, 304) selon l'une des revendications précédentes,
**caractérisé**
- **en ce que** la connexion de communication (207, 307) établie entre le module de mesure (209, 309.1, 309.2) et le module de pair à pair (220, 320) est une connexion de communication filaire (207, 307), et/ou
- **en ce que** la connexion de communication (207, 307) établie entre le module de mesure (209, 309.1, 309.2) et le module de pair à pair (220, 320) est une connexion de communication unidirectionnelle (207, 307) agencée à partir du module de mesure (209, 309.1, 309.2) jusqu'au module de pair à pair (220, 320).

4. Appareil de mesure (204, 304) selon l'une quelconque des revendications précédentes,
**caractérisé**
- **en ce que** l'appareil de mesure (204, 304) est associé à une première entité (306, 506, 606.1), et
- **en ce que** module de pair à pair (220, 320) est configuré pour déclencher une élaboration d'un accord de transaction concernant le milieu d'alimentation, ledit accord étant relatif à l'échange d'un milieu d'alimentation se produisant entre la première entité (306, 506, 606.1) et une autre entité (508, 564, 566, 568, 570, 572, 608.2, 664.1, 666.1, 668.2, 670.2, 672.2), ledit échange étant mis en œuvre par l'application de pair à pair (224, 424).

5. Appareil de mesure (204, 304) selon l'une quelconque des revendications précédentes,
**caractérisé**
- **en ce que** le réseau de pair à pair (222, 522, 622) est formé par une pluralité de nœuds de calcul (226.1, 226.2, 226.3), et
- **en ce que** le module de pair à pair (220, 320) est configuré seulement pour communiquer avec la pluralité de nœuds de calcul (226.1, 226.2, 226.3).

6. Appareil de mesure (204, 304) selon l'une quelconque des revendications précédentes 1 à 5,
**caractérisé**
- **en ce que** le réseau de pair à pair (222, 522, 622) est formé par une pluralité de nœuds de calcul (226.1, 226.2, 226.3), et
- **en ce que** le module de pair à pair (220, 320) est l'un des nœuds de calcul.

7. Appareil de mesure (204, 304) selon l'une quelconque des revendications précédentes,
**caractérisé**
- **en ce qu'**un message de demande comprend un paramètre de quantité du milieu d'alimentation, une période de temps et/ou au moins un critère de transaction, et/ou
- **en ce qu'**un message de réception comprend un paramètre de quantité du milieu d'alimentation, une période de temps et/ou au moins un critère de transaction.

8. Appareil de mesure (204, 304) selon l'une quelconque des revendications précédentes 5 à 7, **caractérisé en ce que** le module de pair à pair (220, 320) est configuré pour déclencher une élaboration d'une transaction basée sur un critère de transaction spécifié dans l'accord de transaction concernant le milieu d'alimentation et basée sur le paramètre de quantité ayant été mesuré.

9. Appareil de mesure (204, 304) selon l'une quelconque des revendications précédentes, **caractérisé en ce que** le module de pair à pair (220, 320) est configuré en outre pour communiquer avec au moins un autre appareil de mesure (305.1, 305.2) via une connexion filaire (315) ou une connexion sans fil.

10. Système d'alimentation (200, 500, 600) comprenant :
- au moins un appareil de mesure (204, 304) selon l'une quelconque des revendications précédentes,
- au moins un conduit d'alimentation (210, 310) configuré pour transporter au moins un milieu d'alimentation,
- au moins un réseau de pair à pair (222, 522, 622) configuré pour fournir une application de pair à pair (224, 424), et
- système d'alimentation dans lequel au moins un sous-ensemble des nœuds de calcul (226.1, 226.2, 226.3) du réseau de pair à pair (222, 522, 622) est configuré pour contrôler que le paramètre de quantité ayant été fourni est correct.

11. Système d'alimentation (200, 500, 600) selon la revendication 10,
**caractérisé**
- **en ce que** l'application de pair à pair (224, 424) est un registre décentralisé (224, 424), et
- **en ce que** le registre décentralisé (224, 424) peut être lu au moins par une partie des participants du réseau de pair à pair (222, 522, 622).

12. Système d'alimentation (200, 500, 600) selon la revendication 10 ou 11, **caractérisé en ce que** l'application de pair à pair (224, 424) comprend des moyens de cryptage et/ou des moyens de signature et/ou des moyens de vérification, application de pair à pair dans laquelle au moins l'un des moyens de cryptage et/ou des moyens de signature et/ou des moyens de vérification est configuré pour stocker en mémoire au moins le paramètre de quantité ayant été fourni.

13. Système d'alimentation (200, 500, 600) selon l'une quelconque des revendications précédentes 10 à 12, **caractérisé en ce que** l'application de pair à pair (224, 424) est une chaîne de blocs (224, 424) ou bien un grand livre décentralisé (224, 424) se composant au moins de deux blocs (446, 448, 450) couplés l'un à l'autre.

14. Système d'alimentation (200, 500, 600) selon l'une quelconque des revendications précédentes 10 à 13, **caractérisé en ce que** le système d'alimentation (200, 500, 600) comprend un autre appareil de mesure (305.1, 305.2) ayant au moins un module de communication (313.1, 313.2) configuré pour communiquer avec le module de pair à pair (220, 320) via une connexion filaire (315) ou une connexion sans fil.

15. Procédé permettant de faire fonctionner un appareil de mesure (204, 304) d'un système d'alimentation (200, 500, 600), en particulier un appareil de mesure (204, 304) selon l'une quelconque des revendications précédentes 1 à 11, procédé dans lequel l'appareil de mesure (204, 304) comprend au moins un module de mesure (209, 309.1, 309.2) et au moins un module de pair à pair (220, 320), ledit procédé consistant :
- à mesurer, par le module de mesure (209, 309.1, 309.2), au moins un paramètre de quantité d'un milieu d'alimentation,
- à transmettre le paramètre de quantité au moins au nombre de un depuis le module de mesure (209, 309.1, 309.2) jusqu'au module de pair à pair (220, 320), via une connexion de communication (207, 307) agencée entre le module de mesure (209, 309.1, 309.2) et le module de pair à pair (220, 320),
- à fournir au moins le paramètre de quantité ayant été mesuré, à une application de pair à pair (224, 424) d'un réseau de pair à pair (222, 522, 622), ledit paramètre de quantité étant fourni par le module de pair à pair (220, 320),
- procédé dans lequel l'appareil de mesure (204, 304) est associé à une entité (306, 506, 508, 564, 566, 568, 570, 572, 606.1, 608.2, 664.1, 666.1, 668.2, 670.2, 672.2), et
- à générer au moins un message de demande et/ou un message de réception, par le module de pair à pair (220, 320), ledit message étant basé sur un plan concernant le milieu d'alimentation, ledit plan ayant été créé pour ladite entité (306, 506, 508, 564, 566, 568, 570, 572, 606.1, 608.2, 664.1, 666.1, 668.2, 670.2, 672.2) associée au module de pair à pair (220, 320), et consistant à déclencher l'élaboration d'un accord de transaction concernant le milieu d'alimentation.
